# EUROPEAN PATENT APPLICATION

(11) **EP 4 770 403 A2**
(43) Date of publication of application: **01.07.2026**
(21) Application number: 26166196.1
(22) Date of filing: 19.03.2026
(51) Int. Cl.: H10P 72/76

(54) **SUBSTRATE CONDITIONING APPARATUS**

(30) Priority: 20.02.2026 EP 26159716
(71) Applicant: ASML Netherlands B.V., 5500 AH Veldhoven (NL)
(72) Inventor: SENESCHAL-MERZ, Karine, Marie-Annick, Danielle, 5500 AH Veldhoven (NL); DAHMS, Steffen, 5500 AH Veldhoven (NL); SCHULZE, Pascal, 5500 AH Veldhoven (NL); BLUME, Christian, 5500 AH Veldhoven (NL)
(74) Representative: ASML Netherlands B.V.

(57) **Abstract**

Disclosed is a substrate support for a substrate processing apparatus, wherein the substrate support is configured to: support a substrate on a first side of the substrate support; receive fluid under pressure at a second side of the substrate support; and direct the fluid under pressure to edges of, and to openings in, the substrate to prevent a conditioning substance applied to a first part of the substrate from contaminating a second part of the substrate, wherein the substrate comprises a wafer clamp, a wafer table, or subcomponents thereof.

## Description

### BACKGROUND

The present invention relates to methods and apparatus usable, for example, in the manufacture of devices by lithographic techniques.

### FIELD

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In device manufacturing methods using lithographic apparatus, an important factor is the yield, i.e. the percentage of correctly manufactured devices, is the accuracy within which layers are printed in relation to layers that have previously been formed. This is known as overlay and the overlay error budget will often be 10nm or less. To achieve such accuracy, the substrate must be aligned to the reticle pattern to be transferred with great accuracy.

The process in which features with dimensions smaller than the classical resolution limit of a lithographic projection apparatus are printed, is commonly known as low-k, lithography, according to the resolution formula CD=k1xλ/NA, where λ is the wavelength of radiation employed (currently in most cases 248 nm or 193 nm), NA is the numerical aperture of projection system in the lithographic projection apparatus, CD is the "critical dimension"-generally the smallest feature size printed and k1 is an empirical resolution factor. In general, the smaller k1 the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET). The term "projection system" as used herein should be broadly interpreted as encompassing various types of optical systems, including refractive optics, reflective optics, apertures and catadioptric optics, for example. The term "projection system" or "projection optics" may also include components operating according to any of these design types for directing, shaping or controlling the projection beam of radiation, collectively or singularly. The term "projection system" may include any optical component in the lithographic projection apparatus, no matter where the optical component is located on an optical path of the lithographic projection apparatus. The projection system may include optical components for shaping, adjusting and/or projecting radiation from the source before the radiation passes the patterning device, and/or optical components for shaping, adjusting and/or projecting the radiation after the radiation passes the patterning device. The projection system generally excludes the source and the patterning device.

The conditioning (e.g., cleaning and/or chemical treatment) of the various surfaces of components used in a lithographic apparatus is critical, for example, cleaning for the removal of particles and organic residues that may have an adverse effect during a device manufacturing process. In some cases, components such as wafer tables and wafer clamps may comprise pre-conditioned surfaces (e.g., cleaned or chemically treated surfaces) that are not compatible with conditioning processes used on different areas of the component (e.g., not compatible with cleaning fluids or chemicals used in a subsequent conditioning process). This can lead to long and protracted reprocessing of such components during refurbishment or repair. It is desirable to have improved conditioning methods for such components that alleviates the requirements for such reprocessing.

### SUMMARY OF THE INVENTION

The invention in a first aspect provides a substrate support for a substrate conditioning apparatus, wherein the substrate support is configured to: support a substrate on a first side of the substrate support; receive fluid under pressure at a second side of the substrate support; and direct the fluid under pressure to edges of, and to openings in, the substrate to prevent a conditioning substance applied to a first part of the substrate from contaminating a second part of the substrate, wherein the substrate comprises a wafer clamp, a wafer table, or subcomponents thereof.

A second aspect provides for a substrate processing apparatus configured to condition at least a first part of a substrate, the apparatus comprising: the substrate support according to the first aspect; a motor arrangement configured to spin the substrate support; at least one nozzle arranged to apply a conditioning substance to the first part of the substrate; and a fluid supply arrangement configured to supply fluid under pressure to the substrate support.

A third aspect provides for a method of conditioning a substrate comprising: supporting the substrate on a substrate support; providing a fluid under pressure to the substrate support; spinning the substrate support while providing a conditioning substance to a first part of the substrate; and directing, by the substrate support, the fluid under pressure to edges of, and to openings in, the substrate to prevent the conditioning substance from contaminating a second part of the substrate, wherein the substrate comprises a wafer clamp, a wafer table, or subcomponents thereof.

The above and other aspects of the invention will be understood from a consideration of the examples described below.

### BRIEF DESCRIPTION OF THE DRAWINGS

Embodiments of the invention will now be described, by way of example only, with reference to the accompanying drawings, in which:
- Figure 1 depicts a lithographic apparatus;
- Figure 2 illustrates schematically measurement and exposure processes in the apparatus of Figure 1;
- Figure 3 depicts a substrate support in accordance with some embodiments;
- Figure 4 depicts a substrate support in accordance with some embodiments;
- Figure 5 depicts a substrate support in accordance with some embodiments; and
- Figure 6 depicts sub-components of a substrate support in accordance with some embodiments.

### DETAILED DESCRIPTION OF EMBODIMENTS

Before describing embodiments of the invention in detail, it is instructive to present an example environment in which embodiments of the present invention may be implemented.

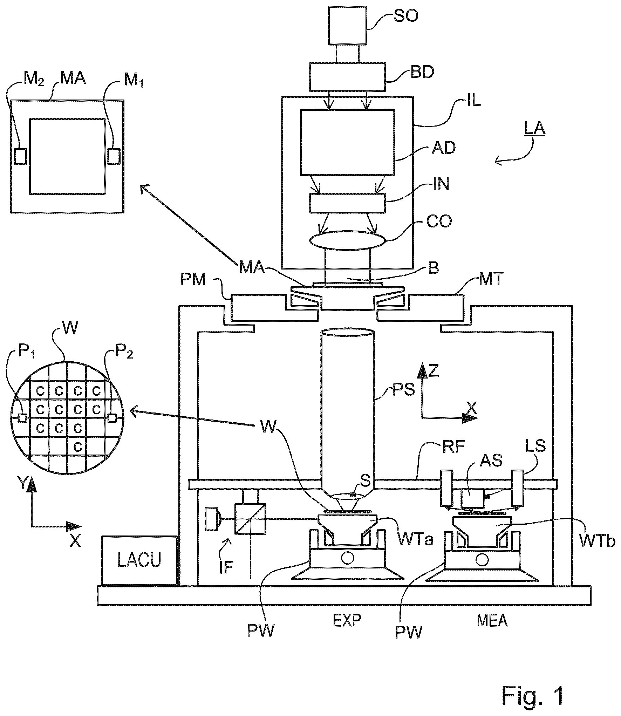

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator may be adjusted. In addition, the illuminator IL may comprise various other components, such as an integrator IN and a condenser CO. The illuminator IL may be used to condition the radiation beam B, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

The lithographic apparatus may comprise an aberration sensor for the verification of an aberration fingerprint of the projection system PS. In an embodiment such an aberration fingerprint, i.e. aberrations per field point of the projection system PS, may be determined using such a wavefront aberration sensor. A wavefront aberration sensor of a known type, for instance such as described in US2002/0001088 may be used. Such a wavefront aberration sensor may be based on the principle of shearing interferometry and comprises a source module and a sensor module. The source module may comprise a patterned layer of chromium that is placed in the object plane (i.e. where during production the pattern of the patterning means is) of the projection system PS and has additional optics provided above the chromium layer. The combination provides a wavefront of radiation to the entire pupil of the projection system PS. The sensor module may comprise a patterned layer of chromium that is placed in the image plane of the projection system (i.e. where during production the substrate W is) and a camera that is placed some distance behind said layer of chromium. The patterned layer of chromium on the sensor module diffracts radiation into several diffraction orders that interfere with each other giving rise to an interferogram. The interferogram is measured by the camera. The aberrations in the projection lens can be determined by software based upon the measured interferogram. The wavefront aberration sensor may be configured to transfer information with respect to the aberration fingerprint towards the control unit.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

The lithographic apparatus control unit LACU which controls all the movements and measurements of various actuators and sensors to receive substrates W and reticles MA and to implement the patterning operations. Lithographic apparatus control unit LACU also includes signal processing and data processing capacity to implement desired calculations relevant to the operation of the apparatus, e.g., based on *inter alia* level sensor LS data, alignment sensor AS data and feedback metrology data (e.g., one or more of *inter alia* overlay, focus, dose, critical dimension data). In practice, control unit LACU may be realized as a system of many sub-units, each handling the real-time data acquisition, processing and control of a subsystem or component within the apparatus.

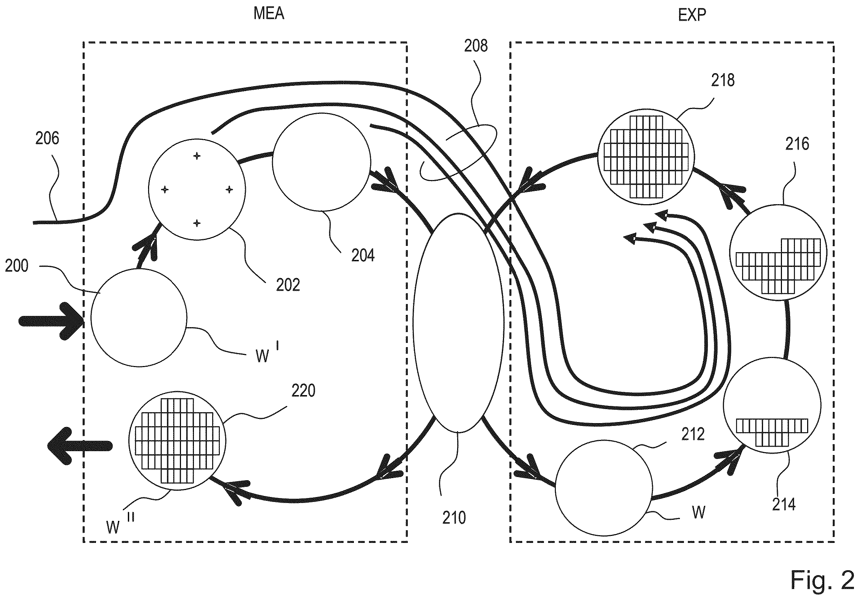

Figure 2 illustrates the steps to expose target portions (e.g. dies) on a substrate W in the dual stage apparatus of Figure 1. On the left hand side within a dotted box are steps performed at a measurement station MEA, while the right hand side shows steps performed at the exposure station EXP. From time to time, one of the substrate tables WTa, WTb will be at the exposure station, while the other is at the measurement station, as described above. For the purposes of this description, it is assumed that a substrate W has already been loaded into the exposure station. At step 200, a new substrate W' is loaded to the apparatus by a mechanism not shown. These two substrates are processed in parallel in order to increase the throughput of the lithographic apparatus.

Referring initially to the newly-loaded substrate W', this may be a previously unprocessed substrate, prepared with a new photo resist for first time exposure in the apparatus. In general, however, the lithography process described will be merely one step in a series of exposure and processing steps, so that substrate W' has been through this apparatus and/or other lithography apparatuses, several times already, and may have subsequent processes to undergo as well. Particularly for the problem of improving overlay performance, the task is to ensure that new patterns are applied in exactly the correct position on a substrate that has already been subjected to one or more cycles of patterning and processing. These processing steps progressively introduce distortions in the substrate that must be measured and corrected for, to achieve satisfactory overlay performance.

The previous and/or subsequent patterning step may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

At 202, alignment measurements using the substrate marks P1 etc. and image sensors (not shown) are used to measure and record alignment of the substrate relative to substrate table WTa/WTb. In addition, several alignment marks across the substrate W' will be measured using alignment sensor AS. These measurements are used in one embodiment to establish a "wafer grid", which maps very accurately the distribution of marks across the substrate, including any distortion relative to a nominal rectangular grid.

At step 204, a map of wafer height (Z) against X-Y position is measured also using the level sensor LS. Conventionally, the height map is used only to achieve accurate focusing of the exposed pattern. It may be used for other purposes in addition.

When substrate W' was loaded, recipe data 206 were received, defining the exposures to be performed, and also properties of the wafer and the patterns previously made and to be made upon it. To these recipe data are added the measurements of wafer position, wafer grid and height map that were made at 202, 204, so that a complete set of recipe and measurement data 208 can be passed to the exposure station EXP. The measurements of alignment data for example comprise X and Y positions of alignment targets formed in a fixed or nominally fixed relationship to the product patterns that are the product of the lithographic process. These alignment data, taken just before exposure, are used to generate an alignment model with parameters that fit the alignment model to the data. These parameters and the alignment model will be used during the exposure operation to correct positions of patterns applied in the current lithographic step. The model in use interpolates positional deviations between the measured positions. A conventional alignment model might comprise four, five or six parameters, together defining translation, rotation and scaling of the 'ideal' grid, in different dimensions. Advanced models are known that use more parameters.

At 210, wafers W' and W are swapped, so that the measured substrate W' becomes the substrate W entering the exposure station EXP. In the example apparatus of Figure 1, this swapping is performed by exchanging the supports WTa and WTb within the apparatus, so that the substrates W, W' remain accurately clamped and positioned on those supports, to preserve relative alignment between the substrate tables and substrates themselves. Accordingly, once the tables have been swapped, determining the relative position between projection system PS and substrate table WTb (formerly WTa) is all that is necessary to make use of the measurement information 202, 204 for the substrate W (formerly W') in control of the exposure steps. At step 212, reticle alignment is performed using the mask alignment marks M1, M2. In steps 214, 216, 218, scanning motions and radiation pulses are applied at successive target locations across the substrate W, in order to complete the exposure of a number of patterns.

By using the alignment data and height map obtained at the measuring station in the performance of the exposure steps, these patterns are accurately aligned with respect to the desired locations, and, in particular, with respect to features previously laid down on the same substrate. The exposed substrate, now labeled W" is unloaded from the apparatus at step 220, to undergo etching or other processes, in accordance with the exposed pattern.

The skilled person will know that the above description is a simplified overview of a number of very detailed steps involved in one example of a real manufacturing situation. For example rather than measuring alignment in a single pass, often there will be separate phases of coarse and fine measurement, using the same or different marks. The coarse and/or fine alignment measurement steps can be performed before or after the height measurement, or interleaved.

The conditioning (e.g., cleaning and/or chemical treatment) of the various surfaces of components used in a lithographic apparatus is critical, for example, for removing particles and/or organic residues that may have an adverse effect during e.g., a manufacturing process. Furthermore, some components of a lithographic apparatus may require a first surface to be treated (e.g., provided with a particular surface chemistry for a subsequent bonding process) and second surface to be conditioned without disturbing or contaminating the treatment of the first surface. In a specific example, a wafer clamp or wafer table may have to be cleaned before being processed in a lithographic apparatus. The manufacturing process of a wafer clamp and/or a wafer table comprises several steps, and between each steps the various parts of the wafer clamp and/or wafer table are cleaned. In some cases, e.g., prior to a bonding step, the surfaces to be bonded are cleaned (e.g., to remove particles and organic residue) to a higher specification than surfaces that are not to be bonded, and chemically conditioned (e.g., to provide a monolar hydroxyl layer at the surface) to obtain a strong bond without defects.

The term conditioning or conditioning process used throughout this disclosure should be understood to comprise any process applied to at least a first part of a surface of a substrate to prepare the surface of the substrate (e.g., for subsequent processes such as bonding). Conditioning processes may comprise, for example, the removal of organic and/or inorganic residues (e.g., using wet and/or dry cleaning processes), or chemical treatments (e.g., to change the surface chemistry at least the first part of the surface of the substrate).

The term substrate conditioning apparatus should be understood to comprise any apparatus suitable for performing the above mentioned conditioning processes. For example, a substrate conditioning apparatus may comprise any of a substrate cleaning system (including, for example, a spin cleaning system), dry and/or wet etching systems, plasma systems such as a plasma etcher, a plasma cleaner or a plasma asher, or any apparatus suitable for chemically modifying the surface of a substrate (e.g., for surface preparation prior to a bonding process).

In other words, a component may have a first side comprising a previously conditioned surface that is not compatible with a conditioning process used for a second side of the component. Examples of such components that may comprise a conditioned first side that is incompatible with a conditioning process associated with a second side of the component include wafer clamps and wafer tables and/or their sub-components such as sheets and/or disks. Such components may be considered (and are referred to henceforth as) substrates.

In a more specific example, an electrostatic wafer clamp (e.g., as used in EUV lithograph apparatus) may comprise a plurality of bonded sheets. Each sheet may have a surface that has been treated or prepared for bonding including the removal of particles. The particle removal process may not be compatible with surfaces of the sheets that have not been prepared for bonding.

Wet-cleaning processes (for example in immersion tanks) enables the removal of particles and organic residues on both sides of a substrate at the same time as channels of wafer clamps and wafer tables (e.g., channels for the distribution of gases for temperature control during operation).

During such a wet cleaning process with immersion tanks, it is not possible to clean only one surface of a substrate, and the entire substrate will be cleaned (including both surfaces and open structures such as channels comprised in the substrate). In case of refurbishment or repair of wafer clamps or wafer tables, those components necessarily follow a full cleaning process chain leading to a time penalty. For example, all surfaces and channels which where not required to be cleaned are treated again (e.g., with chemicals to achieve a particular surface chemistry and/or mechanical support). Additionally, some parts of assembled wafer clamps and/or wafer tables may not be chemically resistant towards conditioning substances such as cleaning fluids and/or chemicals, or should not have contact with water.

CO2 and/or plasma cleaning has been used to enable the removal of particles or organic residue from a single side of a substrate respectively, but neither CO₂ nor plasma cleaning are suitable for the removal of both particles and organic residue (i.e., CO₂ is typically used for removing particles but not organic residue, whereas the opposite is true for plasma cleaning).

Another known method of substrate cleaning is spin cleaning, which is a wet cleaning process that comprises spinning a substrate and using the centrifugal force from the rotation to apply a cleaning substance (e.g., supplied by a nozzle) to a first surface of the substrate. Spin cleaning enables removal of particles and organic residues on one side of a substrate. Some substrates, however, may comprise holes or channels that link the surface being cleaned to a second surface of the substrate. Such holes or channels may act as a conduit for cleaning substances, thus potentially contaminating the second surface of the substrate.

Accordingly, there is a desire for substrate conditioning processes and apparatus that alleviate the above-mentioned drawbacks of typical substrate conditioning processes and apparatus.

Aspects of the present disclosure provide for a substrate conditioning apparatus comprising a substrate support arrangement (such as a chuck or a clamp) configured to secure a substrate and protect a first surface of the substrate which has already been conditioned while a conditioning process is performed on a second side of the substrate. Accordingly, a one-side conditioning process of e.g., a wafer clamp and/or a wafer table or subcomponents thereof is enabled because the presently disclosed chuck is configured to protect the first side of the substrate (for example using a purging fluid such as nitrogen as will be explained further below). The presently proposed apparatus and method of operation therefore enables the conditioning of a first surface of a substrate without contaminating or damaging the other parts of the substrate (e.g., a second surface).

The presently disclosed substrate conditioning apparatus and method enables process steps that are not currently achievable, for example the wet cleaning of assembled clamps.

By virtue of the presently proposed substrate conditioning apparatus, in the case of a surface quality error of a manufacturing component, the surface of interest may be cleaned within a relatively short time frame without having to re-perform a full process chain (e.g., basic cleaning, machine time, transport, precision cleaning and so on). In addition to saving time in the production process, the use of the proposed apparatus uses less cleaning substance than typical systems and generates less waste.

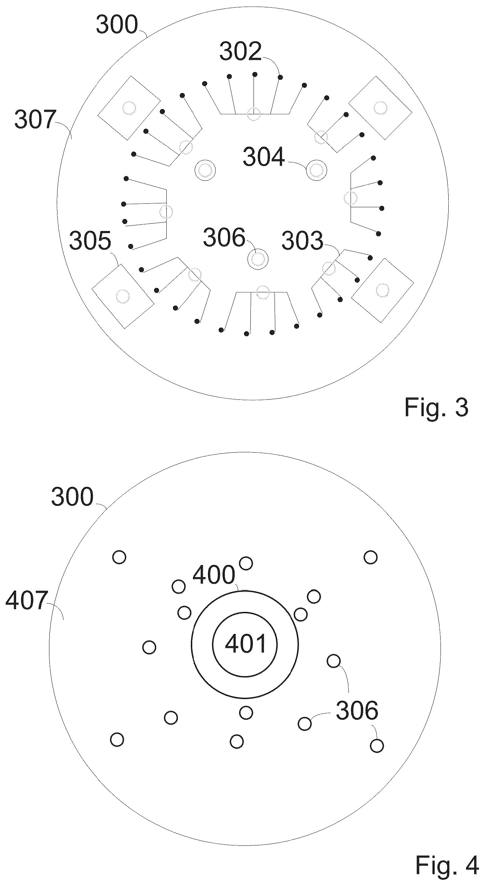

Figure 3 is a purely exemplary schematic diagram of a top down view of a substrate support 300 (showing a first surface 307 of the substrate support 300) in accordance with some aspects of the present disclosure. In the present example, the substrate support 300 comprises a first surface 307 configured to support a substrate (e.g., a substrate to be conditioned). For example, the substrate support 300 may be sized and shaped to accommodate a wafer table, a wafer chuck, or component parts thereof (e.g., such as various sheets and disks that make up the wafer table and/or wafer clamp).

Said substrate support 300 comprises various fluid guides configured to guide a fluid under pressure to various openings and edges of a substrate to be conditioned. In more general terms, a fluid guide may be considered a component configured to vent purging fluid at strategic locations on a substrate to be conditioned such that a conditioning substance applied to a first part or surface of the substrate is prevented from contaminating a second part or surface of the substrate. The number and location of fluid guides and other associated physical paramters such as vent diameter may be selected based on use case scenarios such as substrate shape, a desired purging fluid flow rate and so on. Specific non-limiting examples of fluid guides are provided below. Any combination of the presently disclosed fluid guides on a substrate support 300 may be implemented based on any particular use case.

The term conditioning substance should be understood to comprise any matter applied to a surface of a substrate during a conditioning process, e.g., a cleaning fluid, a plasma, an etchant, a surfactant and so on.

In a first example of a fluid guide, the substrate support 300 may comprise at least one locating pin 304 that extends from the first surface 307 of the substrate support 300. Said locating pin 304 is configured to correspond to openings on a substrate to be conditioned such that the substrate may be secured to the substrate support 300 by the locating pins 304 e.g., during a conditioning procedure (e.g., spin cleaning).

In a specific example wherein the conditioning procedure is a cleaning process, openings on a substrate may act as a conduit for a cleaning substance and direct said cleaning substance to areas of the substrate that may not be compatible with the cleaning substance. Advantageously, the presently proposed locating pin 304 may be configured to supply a purging fluid (e.g., nitrogen gas) under pressure to the openings on the substrate during a conditioning process to direct a conditioning substance away from areas of the substrate that may be subject to contamination from the conditioning substance. Thus, the locating pins 304 may serve two functions: to stabilize the substrate on the substrate support 300 and to provide purging fluid through locating holes in the substrate.

Figure 4 shows a top down view of a second surface 407 of the substrate support 300, i.e., the opposite surface to first surface 307. Said purging fluid may be supplied to the locating pins 304 through the substrate support 300 via valves 306 disposed on the second surface 407 of the substrate support 300 opposite the first surface 307. Said valves 306 are also shown in Figure 3 as grey circles indicating that the valves 306 are disposed on the second (opposite) side 407 of the substrate support 300.

Still referencing Figure 4, the substrate support 300 comprises a hollow shaft 400 disposed on the second surface 407 of the substrate support 300. The hollow shaft 400 is configured to support the substrate support 300, e.g., onto a motor of a substrate conditioning apparatus (i.e., to enable spinning) and is further configured to receive purging fluid within hollow core 401. The hollow shaft 400 may be coupled to the valves 306 (e.g., by hoses not shown) and thus may direct purging fluid received in the hollow core 401 to the locating pins 304 via the valves 306.

Referring back to Figure 3, in a second example of a fluid guide, substrate support 300 may comprise at least one purging hole 302, said at least one purging hole 302 coupled to at least one valve 306 via at least one purging channel 303. Said purging channel 303 acts as a conduit through the substrate support 300 connecting the at least one valve 306 and the at least one purging hole 302 and is configured to convey purging fluid from the at least one valve 306 to the at least one purging hole 302. A location of the at least one purging hole 302 on the first surface 307 of the substrate support 300 is configured to correspond to an outer edge of, and/or at least one hole in, a substrate to be conditioned (for example an ejector pin of an electrostatic chuck).

In a third example of a fluid guide, the substrate support 300 may further comprise at least one edge clamp 305 disposed on the first side 307 of the substrate support 300 and configured to secure a substrate to be conditioned by being located correspondingly to protruding edges of the substrate during a substrate conditioning process. The at least one edge clamp 305 is be configured to direct purging fluid under pressure to an edge of the substrate to be conditioned during a conditioning process such that a conditioning substance is directed away from previously conditioned areas of the substrate. Similar to the at least one purging hole 302 and locating pin 304, the at least one edge clamp 305 is fluidly coupled to at least one valve 306 in order to receive purging fluid through the substrate support 300. Thus, similar to the locating pins 306, the edge clamp 305 serves two functions: to stabilize a substrate on the substrate support 300 and to provide purging fluid under pressure to the substrate.

Although not illustrated, the skilled reader will understand that various combinations and configurations of the presently disclosed fluid guides are possible and the examples described herein should not be taken as limiting. The skilled reader will further understand that combinations of various sub-components is possible, for example a purging channel 303 may be used to fluidly connect valves 306 with locating pins 304 and/or edge clamps 305 if desired (e.g., when a locating pin 304 and/or edge clamp 305 is not collocated with a valve 306).

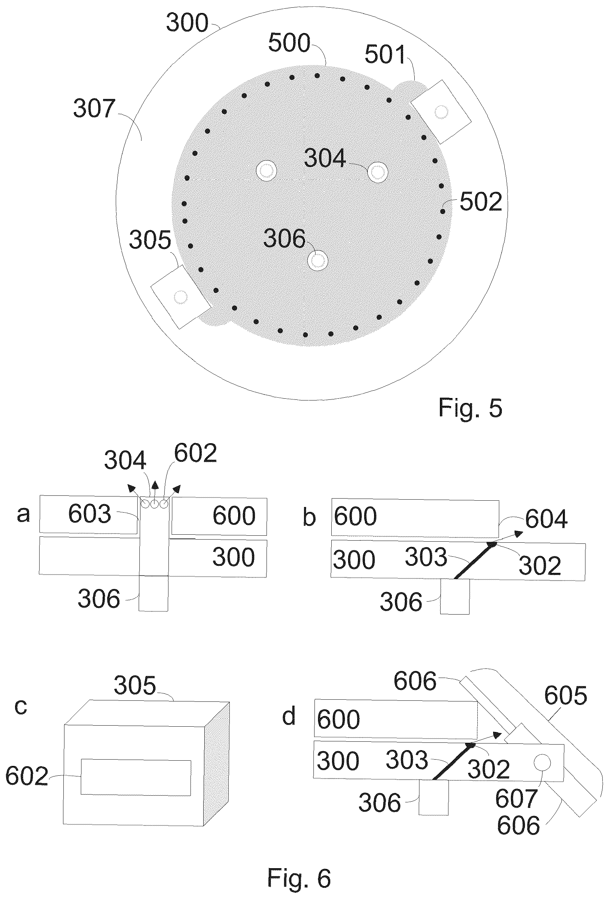

Figure 5 illustrates a purely exemplary use case of the substrate support 300 in a substrate conditioning apparatus comprising a cleaning system, wherein a substrate to be cleaned comprises an electrostatic clamp 500 comprising ears 501 and a plurality of ejector pin holes 502. Figure 5 shows the electrostatic clamp 500 (in grey) mounted onto the first surface 307 of substrate support 300. In the present example, locating pins 304 are configured to correspond to locating holes on the electrostatic clamp 500, edge clamps 305 are configured to correspond to ears 501, and a plurality of purging holes 302 (not shown as obscured by the electrostatic clamp 500) are configured to correspond to the plurality of ejector pin holes 502.

For explanatory purposes, it is assumed that the underside of the electrostatic clamp 500 (i.e., the side that is resting on the substrate support 300) has been conditioned and that the conditioned surface is not compatible with a cleaning process to be used for the topside of the electrostatic clamp 500 (e.g., the conditioned surface of the electrostatic clamp 500 may not be compatible with a conditioning substance such as a cleaning fluid used for the topside of the electrostatic clamp 500). The terms underside and topside are used purely for explanatory purposes in the present example, i.e., the underside of the electrostatic clamp 500 is the side in contact with the substrate support 300 and the topside is the side shown in Figure 5 (as seen from the top down perspective).

In operation, the substrate support 300 comprising the electrostatic clamp 500 is subject to a cleaning operation while spinning. For example, a cleaning substance providing nozzle (as part of the wider spin cleaning system comprising the substrate support 300 and not part of the illustration) may provide a cleaning substance to the topside of the electrostatic clamp 500 while the substrate support 300 (and thus also the substrate supported thereon) is spinning.

Such aforementioned cleaning processes and associated cleaning substances may not be compatible with the conditioned surface on the underside of the electrostatic clamp 500. During the cleaning operation, purging fluid (e.g., nitrogen) under pressure is supplied to edges of, and to openings in, the electrostatic clamp 500. Advantageously, the purging fluid under pressure directs the cleaning substance away from at least a part of the electrostatic clamp 500 (e.g., the underside) that is not compatible with said cleaning substance.

Said purging fluid is provided to the substrate via purging holes (not visible in Fig. 5), locating pins 304 and edge clamps 305 to holes in, and edges of, the electrostatic clamp 500, thus preventing the cleaning substance from reaching conditioned (e.g., cleaned or treated) areas of the electrostatic clamp 500.

Figure 6a-d show exemplary illustrations of a locating pin 304, a purging hole 302, an edge clamp 305 and a weighted clamp respectively.

Figure 6a shows a cross section view of a substrate 600 (e.g., electrostatic clamp 500) disposed on the substrate support 300. A locating pin 304 is shown extending through a locating hole 603 in the substrate 600. Locating pin 304 comprises at least one purging fluid vent 602 configured to vent purging fluid under pressure (as indicated by black arrows) supplied via valve 306 (through the substrate support 300) during a conditioning process. In this way, a conditioning substance may be prevented from entering the locating hole 603 and contaminating previously conditioned surfaces of the substrate 600.

Figure 6b also shows a cross section view of a substrate 600 disposed on the substrate support 300. Figure 6b also shows a substate edge 604, a purging hole 302, a purging channel 303 and a valve 306 according to some examples. In operation, the valve 306 supplies purging fluid to the purging hole 302 via the purging channel 303. Purging fluid under pressure is vented through the purging hole 302 (as indicated by the black arrow) to prevent a conditioning substance from reaching the underside of the substrate 600 (i.e., the side of the substrate 600 that is adjacent substrate support 300).

Figure 6c illustrates an edge clamp 305 according to some examples. Edge clamp 305 comprises a purging fluid vent 602 which operates in a similar way to the purging fluid vent of Figure 6a. That is, in operation, edge clamp 305 may be configured to clamp a substrate edge (e.g., substrate edge 604) during a conditioning process and purging fluid under pressure may be vented from the purging fluid vent 602 to direct a conditioning substance away from at least a portion of the substrate (e.g., substrate 600).

Figure 6d illustrates a weighted edge clamp 604 in accordance with some examples. The weighted clamp 605 comprises a pin 606, hinge 607 and weighted portion 606. The weighted portion 606 is hingedly connected to the substrate support 300 by hinge 607. The weighted edge clamp 604 is biased such that it has a center of gravity below the hinge 607 relative to the location of pin 606. In operation (i.e., when the substrate support 300 is spinning), centrifugal forces cause the weighted edge clamp 604 to rotate around the hinge 607 (anticlockwise with respect to Figure 6d) which in turn causes the pin 606 to move towards the surface of the substrate support 300. Advantageously, the weighted edge clamp 604 may thus secure a substrate (e.g., substrate 600) located between the pin 606 and the substrate support 300. The pin 606 is configured to contact only an edge of the substrate (i.e., not the surface which may have been conditioned and/or may comprise delicate structures). The weighted edge clamp 604 may be useful for securing substrates in cases where a substrate to be conditioned does not comprise mounting holes (e.g., mounting hole 603) or so-called ears (e.g., ears 501) that may be used for securing the substrate (i.e., by locating pins 304 or edge clamps 305 respectively).

The diameter, location and relative number of any of the purging fluid vent 602 and/or the purging hole 302 may be determined based on a desired rate of purging fluid flow, which in turn may be determined based on any particular use case (e.g., diameter, location and relative number of holes comprised in a substrate to be conditioned, and/or relative locations on a substrate to be conditioned that are not compatible with a present conditioning process).

In more general terms, hollow shaft 400, hollow core 401, valves 306, and any configuration of purging holes 302, purging channels 303, locating pins 304 and edge clamps 305 may together be considered to comprise a fluid supply arrangement that is configured to supply purging fluid under pressure via the substrate support 300 to the edges of, and holes or cavities within, a substrate to be conditioned.

Said valves 306 and corresponding purging holes 302, locating pins 304, edge clamps 305 may be modular such that the substrate support 300 can be reconfigured for different use cases (e.g., the cleaning of different substrates comprising a particular configuration of holes and/or substrate edge placement relative to the substrate support 300).

In some examples, the substrate support 300 may be comprised in a cleaning system such as a spin cleaning system. Said cleaning system may be configured to perform various types of cleaning processes on a substrate (e.g., wafer clamps and wafer tables and/or their sub-components such as sheets and/or disks) comprised on the substrate support 300.

Some non-limiting examples of cleaning operations suitable for use with the presently disclosed substrate support 300 may comprise the use of any of a megasonic nozzle, a high pressure nozzle or a spray nozzle to support the release of contamination from at least part of a substrate to be cleaned. In other examples, a brush and/or a sponge may be configured to come into contact with at least part of the substrate to be cleaned (i.e., during rotation of the substrate during the cleaning process) to support the release of contamination from at least part of the substrate and/or to condition the substrate prior to a bonding process. Such components (i.e., megasonic, high pressure and/or spray nozzles, brush or sponge) are well known in the field of substrate conditioning processes and any or all may be included as part of a wider substrate conditioning system comprising the presently disclosed substrate support 300.

In any or all examples a conditioning substance applied to a substrate comprised on the substrate support 300 during a conditioning process may comprise one or more of water, surfactant, base, an acid or a solvent (e.g., isopropanol (IPA), or acetone). In any or all examples, said conditioning substance may be applied using a so-called puddle nozzle. In any or all examples, the condition substance may be applied within a temperature range of 18 to 60 degrees Celsius.

In some examples, when the conditioning substance is water, the water may be doped with CO₂, which enables a less aggressive cleaning process and may further protect a surface of a substrate from corrosion. Furthermore, during operation of a high pressure nozzle or during higher spin cleaning rotation speeds, the friction of molecules on the surface of a substrate may generate a static electrical charge on the substrate that can attract contaminating particles. The use of CO₂ doped and/or deionized water may neutralize such a static electrical charge thus enhancing the removal of particles from the substrate.

Accordingly, aspects of the present disclosure provide for enhanced processing of substrates. Some non-limiting uses cases enabled by the presently proposed system include: one-sided processing of refurbished or repaired wafer clamps and/or wafer tables; etching of soft substrate layers such as chrome or chromium nitride, or soft substrate surfaces such as silicon nitride to release residual stresses post-polishing; surface cleaning prior to substrate coating; surface conditioning prior to bonding, in particular before optical contacting, by controlling the thickness of a water film on the surface to be bonded: hydroxylation processes with water and isopropanol, salinization; and the cleaning of assembled wafer clamps or wafer tables (which is not possible in immersion tanks).

While specific embodiments of the invention have been described above, it will be appreciated that the invention may be practiced otherwise than as described.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The invention is further defined by the following numbered clauses:
1. A substrate support for a substrate conditioning apparatus, wherein the substrate support is configured to:
   support a substrate on a first side of the substrate support;
   receive fluid under pressure at a second side of the substrate support; and
   direct the fluid under pressure to edges of, and to openings in, the substrate to prevent a conditioning substance applied to a first part of the substrate from contaminating a second part of the substrate, wherein the substrate comprises a wafer clamp, a wafer table, or subcomponents thereof.
2. The substrate support of clause 1 further comprising at least one fluid guide configured to direct the fluid under pressure to edges of, and to openings in, the substrate.
3. The substrate support of clause 2, wherein the at least one fluid guide comprises at least one locating pin disposed on the first side of the substrate support, said locating pin configured to correspond to at least one mounting hole on the substrate and to vent the fluid under pressure into the at least one mounting hole.
4. The substrate support of any of clause 2 or clause 3, wherein the at least one fluid guide comprises at least one purging hole disposed on the first side of the substrate support, said at least one purging hole configured to correspond to at least one hole in the substrate and to vent the fluid under pressure towards the at least one hole.
5. The substrate support of any of clauses 2 to 4, wherein the at least one fluid guide comprises at least one edge clamp disposed on the first side of the substrate support, said at least one edge clamp configured to correspond to at least one protruding edge of the substrate and to vent the fluid under pressure to the edge of the substrate.
6. The substrate support of any of clauses 2 to 5, further comprising at least one valve disposed on the second side of the substrate support configured to receive the fluid under pressure and direct the fluid under pressure to the at least one fluid guide.
7. The substrate support of clause 6, wherein the substrate support further comprises at least one purging channel configured to fluidly connect the at least one valve to the at least one fluid guide.
8. The substrate support of clause 6 or clause 7 further comprising a hollow shaft disposed on the second side of the substrate support and fluidly coupled to the at least one valve, the hollow shaft configured to receive the fluid under pressure and direct the fluid under pressure to the at least one valve.
9. A substrate conditioning apparatus configured to condition at least a first part of a substrate, the apparatus comprising:
   the substrate support according to any preceding clause;
   a motor arrangement configured to spin the substrate support;
   at least one nozzle arranged to apply a conditioning substance to the first part of the substrate; and
   a fluid supply arrangement configured to supply fluid under pressure to the substrate support.
10. The apparatus of clause 9, wherein the conditioning substance comprises one or more of water, surfactant, base, an acid or a solvent.
11. The apparatus of any of clause 9 or clause 10 further comprising at least one of a high-pressure nozzle, a megasonic nozzle, or a spray nozzle configured to release of contamination from the first part of the substrate.
12. The apparatus of any of clause 9 to 11 further comprising a brush and/or a sponge configured to contact the first part of the substrate during rotation.
13. The apparatus of clause 12, wherein the sponge and/or the brush are configured to condition the first part of the substrate for a substrate bonding process.
14. The apparatus of any of clauses 9 to 13, wherein the fluid under pressure is nitrogen.
15. The apparatus of any of clauses 9 to 14, wherein the apparatus is a spin cleaning apparatus.
16. A method of conditioning a substrate comprising:
   supporting the substrate on a first side of a substrate support;
   providing a fluid under pressure to a second side of the substrate support;
   spinning the substrate support while providing a conditioning substance to a first part of the substrate; and
   directing, by the substrate support, the fluid under pressure to edges of, and to openings in, the substrate to prevent the condition substance from contaminating a second part of the substrate, wherein the substrate comprises a wafer clamp, a wafer table, or subcomponents thereof.
17. The method of clause 16, wherein the conditioning substance comprises one or more of water, surfactant, base, an acid or a solvent.
18. The method of any of clause 16 or clause 17 further comprising releasing contamination from the first part of the substrate using a high-pressure nozzle, a megasonic nozzle or a spray nozzle.
19. The method of any of clauses 16 to 18 further comprising conditioning the first part of the substrate by causing a brush and/or sponge to come into contact with the first part of the substrate.
20. The method of clauses 19 further comprising conditioning the first part of the substrate for a substrate bonding process using the brush and/or the sponge.
21. The method of any of clauses 16 to 20 wherein the fluid under pressure comprises nitrogen.

The breadth and scope of the present invention should not be limited by any of the above-described exemplary embodiments, but should be defined only in accordance with the following claims and their equivalents.

## Claims

1. A substrate support for a substrate conditioning apparatus, wherein the substrate support is configured to:
support a substrate on a first side of the substrate support;
receive fluid under pressure at a second side of the substrate support; and
direct the fluid under pressure to edges of, and to openings in, the substrate to prevent a conditioning substance applied to a first part of the substrate from contaminating a second part of the substrate, wherein the substrate comprises a wafer clamp, a wafer table, or subcomponents thereof.

2. The substrate support of claim 1 further comprising at least one fluid guide configured to direct the fluid under pressure to edges of, and to openings in, the substrate.

3. The substrate support of claim 2, wherein the at least one fluid guide comprises at least one locating pin disposed on the first side of the substrate support, said locating pin configured to correspond to at least one mounting hole on the substrate and to vent the fluid under pressure into the at least one mounting hole.

4. The substrate support of any of claim 2 or claim 3, wherein the at least one fluid guide comprises at least one purging hole disposed on the first side of the substrate support, said at least one purging hole configured to correspond to at least one hole in the substrate and to vent the fluid under pressure towards the at least one hole.

5. The substrate support of any of claims 2 to 4, wherein the at least one fluid guide comprises at least one edge clamp disposed on the first side of the substrate support, said at least one edge clamp configured to correspond to at least one protruding edge of the substrate and to vent the fluid under pressure to the edge of the substrate.

6. The substrate support of any of claims 2 to 5, further comprising at least one valve disposed on the second side of the substrate support configured to receive the fluid under pressure and direct the fluid under pressure to the at least one fluid guide.

7. The substrate support of claim 6, wherein the substrate support further comprises at least one purging channel configured to fluidly connect the at least one valve to the at least one fluid guide.

8. The substrate support of claim 6 or claim 7 further comprising a hollow shaft disposed on the second side of the substrate support and fluidly coupled to the at least one valve, the hollow shaft configured to receive the fluid under pressure and direct the fluid under pressure to the at least one valve.

9. A substrate conditioning apparatus configured to condition at least a first part of a substrate, the apparatus comprising:
the substrate support according to any preceding claim;
a motor arrangement configured to spin the substrate support;
at least one nozzle arranged to apply a conditioning substance to the first part of the substrate; and
a fluid supply arrangement configured to supply fluid under pressure to the substrate support.

10. The apparatus of claim 9, further comprising at least one of a high-pressure nozzle, a megasonic nozzle, or a spray nozzle configured to release of contamination from the first part of the substrate.

11. The apparatus of any of claims 9 to 10, further comprising a brush and/or a sponge configured to contact the first part of the substrate during rotation.

12. The apparatus of claim 11, wherein the sponge and/or the brush are configured to condition the first part of the substrate for a substrate bonding process.

13. The apparatus of any of claims 9 to 12, wherein the apparatus is a spin cleaning apparatus.

14. A method of conditioning a substrate comprising:
supporting the substrate on a first side of a substrate support;
providing a fluid under pressure to a second side of the substrate support;
spinning the substrate support while providing a conditioning substance to a first part of the substrate; and
directing, by the substrate support, the fluid under pressure to edges of, and to openings in, the substrate to prevent the condition substance from contaminating a second part of the substrate, wherein the substrate comprises a wafer clamp, a wafer table, or subcomponents thereof.
